(19) Europäisches Patentamt / European Patent Office / Office européen des brevets

(11) **EP 2 363 515 A1**

(12) **DEMANDE DE BREVET EUROPEEN**

(43) Date de publication:
**07.09.2011 Bulletin 2011/36**

(51) Int Cl.:
*C30B 11/00* (2006.01)  *C30B 29/48* (2006.01)

(21) Numéro de dépôt: **11305144.5**

(22) Date de dépôt: **11.02.2011**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**

(30) Priorité: **19.02.2010 FR 1000695**

(71) Demandeur: **Société Française de Détecteurs Infrarouges - SOFRADIR 92290 Châtenay Malabry (FR)**

(72) Inventeurs:
• **Paltrier, M. Sylvain 38340, VOREPPE (FR)**
• **Miguet, M. Thierry 38380, ENTRE DEUX GUIERS (FR)**

(74) Mandataire: **Vuillermoz, Bruno et al Cabinet Laurent & Charras "Le Contemporain" 50, Chemin de la Bruyère 69574 Dardilly Cédex (FR)**

(54) **Procédé pour la réalisation d'un matériau semi-conducteur cristallisé**

(57) Ce procédé pour la réalisation d'un matériau semi-conducteur composé cristallisé consiste à synthétiser ledit matériau par fusion et réaction entre eux de ses constituants, lesdits constituants étant placés sous forme élémentaire constituant une charge dans une ampoule scellée (1), puis à cristalliser le matériau semi-conducteur résultant de cette opération alors sous forme liquide par refroidissement de l'ampoule selon un gradient thermique déterminé.

Ce procédé consiste en outre :
- à augmenter au sein de la charge la proportion de l'un des constituants dudit matériau au delà des proportions stoechiométriques du matériau semi-conducteur à synthétiser, définissant un excès de l'un desdits constituants ;
- à soumettre l'intégralité de l'ampoule scellée à une température supérieure ou égale à la température de fusion du matériau semi-conducteur à synthétiser ;
- à soumettre alors l'ampoule à un gradient faible de température et à un abaissement progressif de la température, propres à induire la cristallisation du matériau semiconducteur composé en résultant, alors sous forme liquide, en proportion stoechiométrique ;
- puis, à soumettre la partie de l'ampoule hors le lieu de présence du matériau semi-conducteur cristallisé, à un abaissement de température apte à modifier le régime de pression de vapeur du constituant en excès, afin de l'amener à un régime de vapeur saturante ;
- et enfin, à refroidir l'ensemble jusqu'à température ambiante.

Fig. 2

Fig. 3

**Description**

L'invention concerne un procédé pour réaliser un matériau semi-conducteur cristallisé, notamment de type II-VI du tableau périodique des éléments.

Elle vise notamment la réalisation de tels matériaux semi-conducteurs, binaires de type CdTe ou ZnTe, ou ternaires de formule $Cd_xZn_{1-x}Te$, où x peut prendre toutes valeurs comprises en zéro et un, et classiquement identifiés par la formule générique CdZnTe ou encore $CdTe_ySe_{1-y}$, où y peut la encore prendre toutes valeurs comprises entre zéro et un, voire même quaternaires de formule générique $Cd_xZn_{1-x}Te_ySe_{1-y}$.

De manière générale, la présente invention s'applique à l'élaboration de tels matériaux semi-conducteurs réalisée en ampoule scellée sous gaz neutre ou réducteur ($H_2$), ou encore sous vide, selon la technique de BRIDGMAN par exemple. La méthode de croissance mise en oeuvre n'est pas déterminante dans le cadre de la présente invention.

Les matériaux ainsi obtenus sont plus particulièrement destinés à servir de substrat pour l'épitaxie de composés semi-conducteurs de formule générique CdHgTe, bien connus pour la réalisation de détecteurs infrarouges.

Les matériaux en question sont également connus pour être exploités dans le cadre de la réalisation de détecteurs de rayons X ou de rayons gamma (y), et de manière générale de détecteurs de rayonnement ionisant.

## ETAT ANTERIEUR DE LA TECHNIQUE

La demande en matériaux semi-conducteurs monocristallins de taille suffisamment importante est sans cesse croissante, compte tenu des nombreuses applications envisagées. Or la réalisation de matériaux de telles tailles est antinomique avec une production satisfaisante sur le plan économique.

Parmi les difficultés rencontrées, on peut mentionner la faible conductivité thermique de ces matériaux, qui entrave l'évacuation des calories générées par la cristallisation, et conduit à des formes d'interfaces de croissance peu favorables à la mono cristallisation.

Ensuite, les constituants desdits matériaux étant des éléments assez volatils, notamment le cadmium ou le sélénium, il est nécessaire de réaliser les opérations de croissance dans des ampoules scellées, étanches, en verre de silice principalement.

En outre, une difficulté majeure résidant dans la réalisation de ces matériaux qui sont ces composés définis, est relative au contrôle de leur stoechiométrie lors de leur élaboration.

Ce défaut de maîtrise entraîne la précipitation du constituant en excès, induisant divers désordres associés, dont notamment la perturbation de l'ordre cristallin ou encore l'opacité du matériau au niveau de ces défauts, opacité rédhibitoire pour un certain nombre d'applications, telles que notamment les fenêtres infrarouges, les lentilles infrarouges, et surtout l'utilisation en tant que substrats transparents pour l'épitaxie de couches minces de CdHgTe destinées à l'élaboration de composants de visionique infra-rouge.

Afin de s'affranchir de ces difficultés, deux voies différentes ont été proposées à ce jour.

La première voie consiste à opérer une correction de stoechiométrie postérieurement à la réalisation du matériau. Les défauts de stoechiométrie, se traduisant principalement sous la forme de précipités, sont corrigés en soumettant le matériau à des recuits sous pression contrôlée de l'un des constituants.

Ainsi, on a proposé, de manière satisfaisante, l'effacement des précipités de tellure par recuits sous vapeur de cadmium. Par exemple, la publication de Li WANWAN et al - « Study on the effect of Cd diffusion annealing on the electrical properties of CdZnTe » - Journal of Crystal Growth 292 (2006), précise qu'il s'avère difficile de contrôler correctement la pression du cadmium pendant la croissance, et qu'un traitement ultérieur, en l'espèce de recuit de diffusion de Cd est requis. La publication de H.R. VYDYANATH et al - « Recipe to minimize Te precipitation in CdTe and (Cd,Zn)Te crystals » - J ; Vac. Sci. Technol. B 10(4) - Jul/aug 1992 préconise également un traitement ultérieur sur tranches après découpe (wafers) afin de réduire les précipités de tellure.

L'expérience démontre cependant que si cette solution technique de recuits réalisés sur des plaques découpées (wafers) ou sur un lingot lui-même présente une réelle efficacité quant à la disparition de l'élément en excès, elle est sans effet sur la perturbation cristallographique induite préalablement par les précipités, perturbation qui persiste.

La seconde voie proposée vise à intervenir plus tôt, au niveau du procédé de croissance du matériau lui même.

Selon cette voie, une méthode telle que par exemple décrite dans le document US 4 190 486 consiste à disposer dans l'ampoule de croissance un réservoir auxiliaire contenant à l'état liquide l'élément le plus volatil du matériau semi-conducteur à réaliser, par exemple le cadmium, dans une zone à significativement plus basse température que celle de la zone de l'ampoule recevant la charge en cours de cristallisation, cette dernière étant typiquement soumise à une température voisine de 1.100 °C pour les composés de type CdTe ou CdZnTe.

Le pilotage de la température de la zone de l'ampoule contenant le réservoir auxiliaire avec l'élément le plus volatil à l'état liquide permet de fixer de manière contrôlée la pression de vapeur s'établissant, en l'espèce la pression de vapeur saturante, et corollairement, la stoechiométrie du matériau en cours de cristallisation.

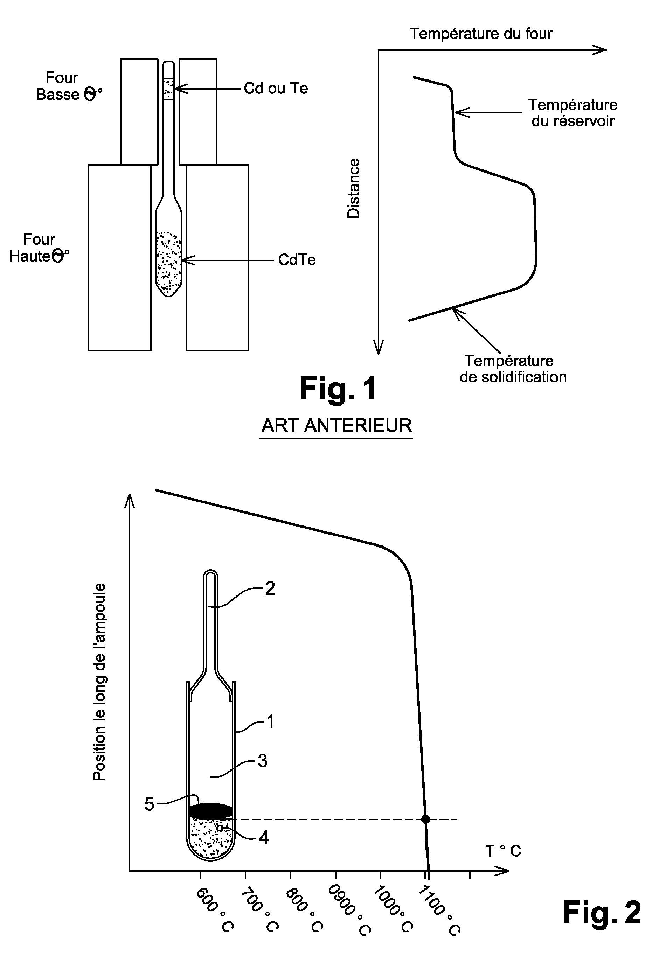

On a représenté en relation avec la figure 1 le principe mis en oeuvre.

Selon les enseignements de ce document, on contrôle de manière satisfaisante la stoechiométrie du matériau.

Cependant, cette méthode impose que l'ampoule de croissance doit être chargée d'une part, en composé CdTe à cristalliser, et non en ses constituants élémentaires, et d'autre part, de l'élément dont on souhaite piloter la pression de vapeur saturante, par exemple disposé dans un réservoir auxiliaire.

En effet, il n'est pas envisageable de charger les éléments simples, Cd et Te par exemple, et d'en effectuer la synthèse pour obtenir le composé CdTe. Cette synthèse nécessite en effet d'élever la température de l'ampoule au moins jusqu'à la température du point de fusion du composé CdTe ($\approx$ 1.100 °C), et ce de manière sensiblement isotherme dans tout le volume de l'ampoule, afin d'éviter d'engendrer la condensation dudit composé dans la partie de l'ampoule, qui autrement se trouverait en zone plus froide. A une telle température de 1.100 °C régnant dans l'intégralité du volume de l'ampoule, la pression de vapeur saturante de cadmium atteindrait environ 10 bars, incompatible avec la résistance mécanique de ladite ampoule.

Cela suppose donc, en premier lieu, une synthèse préalable du composé semi conducteur CdTe, puis le démoulage de celui-ci, et enfin son rechargement dans une nouvelle ampoule pour sa fusion et sa recristallisation sous pression de vapeur saturante contrôlée de l'élément le plus volatil, en vue d'obtenir la stoechiométrie souhaitée.

On conçoit aisément que ces différentes étapes impliquent un processus long, complexe, et onéreux, dicté en outre par les conditions de synthèse elle-même, qui devant s'effectuer de manière sensiblement isotherme à une température supérieure à la température de fusion du composé à synthétiser, et en l'espèce 1.100 °C pour le composé CdTe, exclut la présence d'un élément volatil en large excès en raison de la pression élevée en résultant et de l'incapacité pour l'ampoule d'y résister.

On conçoit de fait que la méthode décrite dans ce document n'est en aucun cas adaptée à une mise en oeuvre industrielle du principe préconisé, en tout cas satisfaisante sur le plan économique.

On a également décrit dans le document US 5 603 763 un procédé de croissance d'un matériau semi-conducteur monocristallin. Ce document préconise également de faire appel à un réservoir auxiliaire, destiné à recevoir un élément volatil, outre à un creuset indispensable à la réception des constituants dudit matériau. Dans le procédé ainsi décrit, la source de vapeur saturante dudit élément volatil est, là encore, positionnée du coté opposé au lieu de départ de la croissance du monocristal. Cette configuration est rendue impérative en raison des perturbations thermiques engendrées par la température relativement basse de la source liquide de vapeur saturante.

On relève donc que l'état antérieur de la technique propose la mise en oeuvre d'un excès de l'un des constituants élémentaires sous forme gazeuse et à l'état de vapeur saturante.

L'objectif visé par la présente invention est de considérablement simplifier les procédés précités, là encore, en jouant sur les conditions de synthèse du matériau semi-conducteur, et en s'affranchissant des perturbations desdits procédés.

**EXPOSE DE L'INVENTION**

Ainsi, et selon l'invention, le procédé pour la réalisation d'un matériau semi-conducteur composé cristallisé, et notamment de type II-VI, consiste à synthétiser ledit matériau par fusion et réaction mutuelle de ses constituants jusqu'à la température de fusion du composé, lesdits constituants étant placés à l'état élémentaire sous la forme d'une charge dans une ampoule scellée sous gaz neutre ou réducteur ou sous vide, puis à cristalliser le matériau semi-conducteur résultant de cette opération alors sous forme liquide par refroidissement de l'ampoule selon un gradient thermique déterminé.

Selon l'invention, le procédé consiste en outre :

- à augmenter au sein de la charge la proportion de l'un des constituants du matériau au delà des proportions stoechiométriques du matériau semi-conducteur composé à synthétiser, définissant ainsi un excès de l'un desdits constituants ;
- à soumettre l'intégralité de l'ampoule scellée ainsi munie de la charge à une température supérieure ou égale à la température de fusion du matériau semi-conducteur composé à synthétiser, induisant d'une part, la fusion effective de la charge et la réaction de ses constituants alors sous forme liquide entre eux, et d'autre part, la transformation en vapeur sèche de l'excès du constituant en excès ;
- à soumettre alors l'ampoule à un gradient faible de température et à un abaissement progressif de ladite température, propres à induire la cristallisation du matériau semi-conducteur en résultant alors sous forme liquide et en proportion stoechiométrique, l'excès du constituant en excès demeurant sous forme de vapeur sèche ;
- puis, après cristallisation et avoir entrepris le refroidissement du matériau semi-conducteur, à soumettre la partie de l'ampoule hors le lieu de présence du matériau semi-conducteur cristallisé, à un abaissement significatif de température apte à modifier le régime de pression de vapeur de l'excès du constituant en excès pour le transformer en vapeur saturante ;
- et enfin, à refroidir l'ensemble jusqu'à température ambiante.

En d'autres termes, l'invention consiste à charger en excès l'ampoule en l'un des constituants du matériau semi-conducteur composé que l'on souhaite réaliser, de manière telle qu'en suite de l'élévation de température propre à induire la fusion du mélange, la réaction de ses constituants et la formation dudit matériau semi conducteur alors sous forme liquide, il se génère au sein de l'ampoule une pression de vapeur sèche dudit constituant en excès, propre à aboutir, lors de la phase subséquente de cristallisation, à l'écart à la stoechiométrie stricte recherchée du matériau, sans pour autant accéder à une valeur trop élevée de la pression, susceptible de briser l'ampoule, puis, à soumettre une zone de l'ampoule à une diminution importante de température au moins pendant une partie de la phase de refroidissement du solide pour induire le changement de nature de la pression dudit constituant en excès pour aboutir à sa condensation (vapeur saturante) et corollairement, permettre ultérieurement un accompagnement du refroidissement sous les conditions de pression choisies, de telle sorte à contrôler la stoechiométrie du matériau alors cristallisé en cours de refroidissement, à l'instar de ce que l'état antérieur de la technique décrit (Cf. supra).

Dit encore autrement, lors de l'étape de chauffage de l'ampoule, notamment à une température voisine de la température de fusion du composé semi-conducteur à réaliser, la quantité de l'élément en excès d'une part, et les lois de la thermodynamique d'autre part, font que ledit excès de constituant en excès se présente alors sous forme de vapeur sèche, de pression compatible avec la résistance mécanique de l'ampoule, et non pas sous forme de vapeur saturante, de pression incompatible avec ladite résistance mécanique. Ainsi, la pression de la quantité en excès de l'élément en excès croît avec la température de manière linéaire (selon la Loi de Mariotte), et non pas de manière exponentielle, comme cela est bien connu de l'homme du métier outre des ouvrages spécialisés, et notamment "VAPOR PRESSURE OF THE CHEMICAL ELEMENTS" de A.N. NESMEYANOV- Edit. R. GARY, Elsevier Publishing Company. Ce faisant, la pression à l'intérieur de l'ampoule scellée, demeure gérable, et en tout cas inférieure à la pression susceptible d'entraîner son éclatement, dans la mesure où ladite quantité en excès demeure limitée.

Ce faisant, on dispose d'une quantité suffisante à l'état élémentaire de l'un des éléments entrant dans la constitution du matériau composé semi-conducteur à réaliser, susceptible d'intervenir subséquemment, c'est-à-dire, lors du refroidissement de l'ampoule et donc de son contenu, et corollairement, postérieurement à la cristallisation dudit matériau, pour optimiser la stoechiométrie et les propriétés électroniques de ce dernier (comblement de lacunes éventuelles par exemple), sans se heurter aux inconvénients de l'art antérieur, et notamment, sans avoir à générer préalablement une charge dudit matériau semi-conducteur à réaliser, mais en partant directement de ses constituants élémentaires.

De manière connue, la réaction mutuelle des constituants entrant dans la composition du matériau semi-conducteur, consiste à passer de la juxtaposition desdits constituants élémentaires et indépendants au degré d'oxydation zéro, non porteurs de charges électriques, à un composé défini, dont le métal est un cation et le métalloïde un anion, même à l'état liquide. La simple mise en contact de ces constituants à l'état élémentaire, de préférence à l'état fondu, produit la réaction, vive et exothermique de constitution du matériau semi-conducteur.

Outre le fait que la vapeur sèche de l'élément ou constituant en excès permet de modérer de manière adaptable la pression supportée par l'ampoule, sa valeur peut être choisie par application de la Loi de Mariotte pendant la cristallisation et au début du refroidissement pour conférer au matériau toute propriété dépendant de ce paramètre (transparence, propriétés électriques, etc.)

Selon l'invention, on choisit comme constituant en excès le mieux adapté à l'obtention des propriétés recherchées : propriétés optiques (transparence, précipités), propriétés électriques : type P ou type N, résistivité haute ou basse, etc.

Selon une caractéristique avantageuse mais non impérative de l'invention, l'ampoule en question comporte deux zones, présentant deux diamètres différents :

- une zone de plus grand diamètre, destinée à servir de lieu de réception de la charge à cristalliser ;
- une zone de plus petit diamètre, en continuité avec la zone de plus grand diamètre, destinée à être soumise à la gestion localisée de température et corollairement au changement de nature, de vapeur sèche à vapeur saturante, de la vapeur du constituant en excès.

Typiquement, dans le cas des alliages de type CdZnTe élaborés sous pression contrôlée de cadmium, la pression de la vapeur lors de la phase de croissance est voisine de 1,5 bar (1,5 $10^5$ Pa). Cette valeur est bien évidemment susceptible de varier en fonction des caractéristiques de résistance mécanique des ampoules, en termes de diamètre et d'épaisseur des parois qui la définissent.

Selon l'invention, l'excès de constituant en excès est au plus égal à la quantité correspondant à l'établissement, à une température légèrement supérieure ou égale à la température de fusion du matériau semi-conducteur composé à réaliser, d'une pression haute dudit constituant, alors sous forme de vapeur sèche, inférieure à la pression de l'éclatement de l'ampoule, cette quantité étant déterminée par application de la loi de MARIOTTE. Par légèrement supérieure, on entend simplement d'au plus quelques dizaines de degrés, et typiquement 20 degrés. Au demeurant, il n'existe aucune raison d'augmenter exagérément la température de l'ampoule au dessus de la température de fusion du matériau composé à réaliser, si ce n'est pour s'assurer de la fusion complète dudit matériau.

Selon l'invention, les matériaux en question sont les matériaux binaires de type CdTe ou ZnTe, ou des matériaux ternaires de formule générique CdZnTe, CdTeSe, ou encore des matériaux quaternaires de formule générique CdZn-TeSe.

## DESCRIPTION DES FIGURES

La manière dont l'invention peut être réalisée, et les avantages qui en découlent, ressortiront mieux de l'exemple de réalisation qui suit donné à titre indicatif et non limitatif à l'appui des figures annexées.

La figure 1 est une représentation schématique du principe mis en oeuvre dans l'état antérieur de la technique.

La figure 2 est une représentation schématique visant à illustrer la phase de croissance ou de cristallisation du matériau semi conducteur selon l'invention.

La figure 3 est une vue analogue à la figure 2 représentant, pendant la phase de refroidissement du solide, la transformation de la nature de la pression de vapeur du constituant dudit matériau dont on a choisi de piloter la pression.

La figure 4 est une représentation schématique d'un détail de la figure 3.

La figure 5 représente un diagramme de phases pression/température pour le composé CdTe, visant à illustrer diverses possibilités de mettre en oeuvre l'invention, en présentant deux exemples d'évolution possible de la pression de cadmium, tout d'abord sous forme de vapeur sèche, puis de vapeur saturante.

## DESCRIPTION DETAILLEE DE L'INVENTION

La description qui suit est plus particulièrement dirigée vers la formation d'un matériau semi-conducteur de type CdTe. Il est cependant bien entendu que la méthode décrite est applicable à d'autres compositions, notamment binaires et par exemple ZnTe, ternaires de type CdZnTe ou CdTeSe, ou quaternaires de type CdZnTeSe.

De même, cette description est plus particulièrement dirigée vers la croissance du matériau CdTe sous pression contrôlée de cadmium. Rien ne s'oppose néanmoins à conduire cette même élaboration sous pression contrôlée de tellure.

En outre, le procédé selon l'invention, et décrit ci-après met en oeuvre la croissance cristalline de mono cristaux par méthode dite de BRIDGMAN ou méthodes analogues en ampoule scellée **1**.

La méthode de BRIDGMAN, par ailleurs illustrée dans le document US 4 190 486 précité, consiste à faire croître des matériaux placés sous ampoule scellée, ladite ampoule étant ensuite chauffée puis refroidie selon un gradient de température de sorte que lesdits matériaux se trouvent en phase liquide dans la partie haute de l'ampoule, avec présence du matériau cristallisé dans la partie basse de l'ampoule.

On sait cependant qu'il est possible d'effectuer ce type de croissance en débutant cette dernière par la surface du bain liquide et en la poursuivant en direction du fond de l'ampoule. En tout état de cause, quelle que soit la méthode retenue, elle est sans incidence sur la mise en oeuvre de l'invention.

L'ampoule **1** est placée dans un four à température contrôlée, voire même dans un ensemble constitué par l'association de deux fours accolés l'un à l'autre. Elle est ensuite tirée vers le bas de la zone chaude vers la zone froide afin de provoquer la cristallisation. Alternativement, l'ampoule peut demeurer fixe, et la cristallisation résulte alors du déplacement du gradient de température. Là encore, ces modes d'exécution ne sont pas constitutifs de l'invention.

L'ampoule est ensuite brisée pour récupérer le cristal.

L'invention consiste dans un premier temps à placer au sein de l'ampoule **1** une charge contenant les constituants élémentaires du matériau semi-conducteur à réaliser, en l'espèce du cadmium et du tellure. Ces constituants se présentent sous forme de lingotins. On prend soin de placer dans ladite charge l'un des constituants, et par exemple le plus volatil, en excès, en l'espèce le cadmium, par rapport aux quantités nécessaires pour aboutir à la stoechiométrie recherchée du semi-conducteur cristallisé que l'on souhaite obtenir, et constitué en fait par un mélange équi-atomique du métal (Cd) et du métalloïde (Te). Si certes ce mélange doit être pesé avec soin, il ne requiert pas pour autant une extrême précision, dans la mesure où le système s'oriente de facto vers un équilibre.

On détermine cette masse en excès par application de la loi de MARIOTTE bien connue :

$$P \text{ x } V = N \text{ x } R \text{ x } T$$

expression dans laquelle :

- P désigne la pression de vapeur sèche du constituant en excès ;
- V désigne le volume gazeux (volume total de l'ampoule diminué du volume du solide) ;
- N désigne la quantité de matière en moles du constituant en excès ;
- R est la constante des gaz parfaits ;
- et T désigne la température.

L'une des difficultés de l'invention est de déterminer cette quantité de cadmium en excès de telle sorte que la pression résultant de la transformation en vapeur de l'excès de cadmium au sein de l'ampoule soit comprise entre deux valeurs :

- une valeur maximum inférieure à la pression d'éclatement de l'ampoulé
- une valeur minimum supérieure à la pression de vapeur saturante du cadmium que l'on souhaite établir au sein de l'ampoule en cours de refroidissement.

La raison de cette fourchette de valeurs sera indiquée ci-après.

Afin de déterminer la quantité maximum admissible du constituant en excès, en l'espèce le cadmium, on considère la pression maximum admissible $P_{max}$ par l'ampoule à la température de synthèse, c'est-à-dire à la phase du procédé de l'invention à haute température, en l'espèce légèrement supérieure ou égale à 1.092° C, et typiquement 1.100 °C correspondant sensiblement à la température de fusion du matériau semi-conducteur composé CdTe.

Bien évidemment, cette pression dépend éminemment de la géométrie de l'ampoule, mais également de sa matière première. Ces paramètres constituent des éléments bien connus de l'homme du métier qui, *in fine,* applique un coefficient de sécurité afin d'éviter le bris de l'ampoule.

On détermine ensuite le volume libre $V_{libre}$ dans l'ampoule, c'est-à-dire le volume total de cette dernière, diminué du volume du bain **4** à cristalliser, ledit bain résultant lui-même de la fusion de la charge.

Quelques incertitudes peuvent subsister quant au volume occupé par le bain, de l'ordre de quelque pourcents mais cependant, l'erreur induite sur la pression ne dépasse alors pas ce pourcentage.

On considère alors que l'espèce en excès en phase gazeuse à la température de travail, c'est-à-dire une température maximum légèrement supérieure ou égale à 1.100° C est une vapeur sèche. Ceci est facilement vérifié par référence aux ouvrages spécialisés et par exemple « VAPOR PRESSURE OF THE CHEMICAL ELEMENTS » de A.N. NESMEYANOV- Edit. R. GARY, Elsevier Publishing Company.

On détermine alors la quantité maximum $N_{max}$ de l'excès du constituant en excès, et dans le cas présent de cadmium, par la relation :

$$N_{max} = P_{max} \; x \; V_{libre} \; / \; R \; x \; T_{synthèse} \qquad (1)$$

expression dans laquelle $T_{synthèse}$ désigne ladite température de travail.

Dès lors que l'on fixe la pression maximale admissible $P_{max}$, avec la marge de sécurité requise, on détermine ainsi facilement la quantité $N_{max}$ de l'excès du constituant volatil en excès.

De manière analogue, on détermine la quantité minimale de l'excès du constituant en excès de telle sorte à pouvoir disposer dudit constituant en excès sous forme de vapeur saturante au niveau de l'extrémité froide **2** de l'ampoule **1**.

Cette quantité dépend de la pression de vapeur saturante dudit constituant à une température choisie dite de « point froid », c'est-à-dire à une température induisant le passage de la nature de la pression du cadmium de sèche à saturante. Cette température dite de « point froid » est librement choisie entre 400 °C et 800°C.

A l'aide de l'équation d'état des gaz selon la loi de MARIOTTE, on détermine ainsi la quantité de matière en excès, cette quantité de matière devant être légèrement supérieure à la valeur indiquée par ladite équation, afin que l'on dispose à la fois au sein de l'ampoule, une phase liquide du cadmium, résultant de sa condensation et, une phase vapeur saturante. A cet effet, on applique la relation :

$$N_{min} = P_{sat} \; x \; V_{libre} / \; R \; x \; T_{"point\ froid"} \qquad (2)$$

La valeur de la pression de vapeur saturante du cadmium $P_{sat}$ résulte également de la littérature concernée, telle que celle précédemment indiquée.

Certes au plan pratique, le gradient de température présent dans l'ampoule lors de la phase de cristallisation induit un gradient de densité de matière dans la phase gazeuse. Ce faisant, l'expression (2) ne donne pas une représentation rigoureuse de la réalité. Néanmoins, l'intégration de la loi de MARIOTTE le long d'un gradient thermique, par exemple linéaire, conduit à une variation de la formule, selon l'expression suivante :

$$N_{min} = Log\ T_{max}/\ Tp_{sat}\ x\ P_{sat}\ x\ V_{libre}\ /\ R\ x\ (T_{max} - Tp_{satt}). \qquad (3)$$

La correction apportée de quantité de matière qui en résulte est en fait minime.

Au demeurant, la formule simplifiée (2) amène à majorer la quantité de matière minimum requise et sécurise alors l'approche technique retenue au visa de la présente invention.

Une fois cette quantité de constituant en excès déterminée, et donc choisie comprise entre les deux valeurs précitées, celle-ci est rajoutée à la charge mise en place au sein de l'ampoule scellée.

On soumet (figure 2) l'intégralité de l'ampoule, c'est-à-dire la partie inférieure **3** de diamètre plus important et la partie supérieure **2** de diamètre moins important, à une température légèrement supérieure ou égale à 1.100°C, c'est-à-dire supérieure à la température de fusion du composé défini CdTe.

On procède alors à l'étape de cristallisation par abaissement lent de température, outre soumission de l'intégralité de l'ampoule à un gradient de température faible, typiquement 1°C/cm, aboutissant au passage de la température de solidification, de sorte que la surface **5** du bain liquide **4** fasse apparaître le monocristal en cours de solidification, et ce, jusqu'à ce que toute la charge soit cristallisée. Tout le liquide a alors disparu au sein de l'ampoule. Seuls demeurent le monocristal de CdTe et du cadmium gazeux sous pression de vapeur sèche.

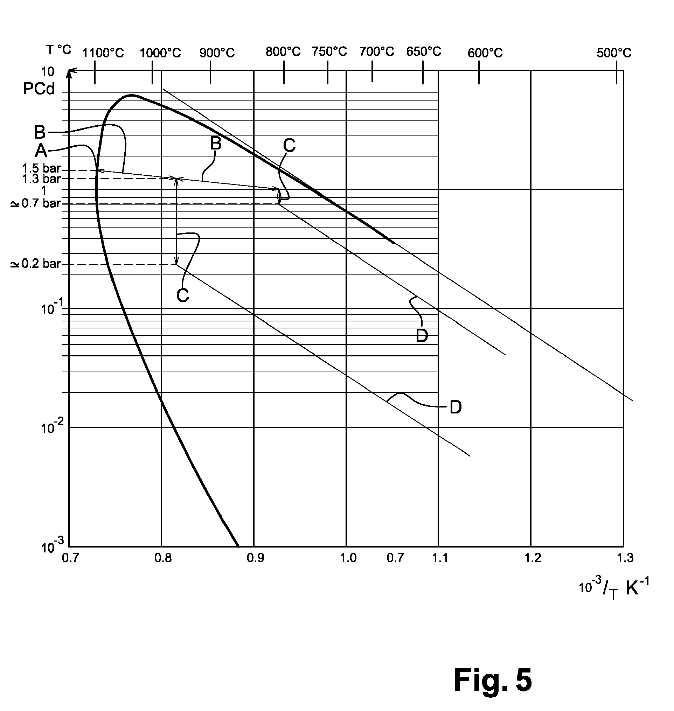

En raison de la quantité en excès de cadmium préalablement placée dans la charge, il se crée dans le volume libre de l'ampoule une pression de vapeur sèche de cadmium typiquement comprise entre 0,5 et 1,5 bar, et dans l'exemple décrit en relation avec la figure 5, précisément égale à 1,5 bar.

En raison de la présence de cette vapeur sèche de cadmium au sein de l'ampoule, on aboutit entre autre, au comblement des éventuelles lacunes susceptibles de se former en cours de cristallisation du bain **4** pour aboutir à la stoechiométrie recherchée du matériau semi-conducteur cristallisé. Cet accompagnement du solide cristallisé par la pression de vapeur du cadmium pendant cette première partie du refroidissement est illustré par la courbe B représentée sur la figure 5. Dans les faits, l'abaissement lent de température entraine simultanément un abaissement de la pression du cadmium en excès, de manière linéaire (et non pas de manière exponentielle, en raison de la nature sèche de la vapeur de cadmium).

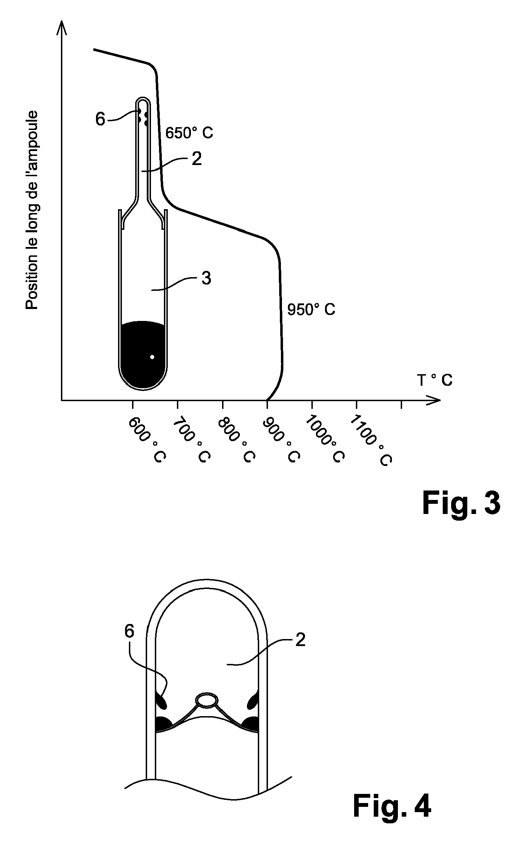

Selon une première conduite du procédé conforme à l'invention, on laisse la température descendre jusqu'à environ 950 °C, puis on procède alors (figure 3) au refroidissement plus net de la zone **2** de plus faible diamètre de l'ampoule, en l'espèce à une température voisine de 650°C.

De par l'abaissement de la température au niveau de cette zone, la pression de vapeur sèche de cadmium s'abaisse selon la Loi de Mariotte au sein de l'ampoule jusqu'à atteindre la pression de vapeur saturante, de sorte que le cadmium en excès se condense et forme ainsi des gouttelettes **6** au sein de cette zone **2** de l'ampoule. On s'affranchit ainsi, lorsque cela est requis, des risques d'apparition de précipités de cadmium au sein du monocristal de CdTe, susceptibles, comme déjà indiqué, d'altérer les propriétés, notamment de transparence dudit cristal. De la même manière, en jouant sur la pression de la vapeur de cadmium, on peut moduler la capacité d'absorption des porteurs libres par le matériau semi conducteur composé cristallisé, jouer sur le dopage de ce dernier, type P ou type N, moduler également sa résistivité....

La pression de la vapeur de cadmium s'abaisse alors significativement, jusqu'à atteindre une valeur voisine de 0,2 bar, puis décroit au fur et à mesure de la baisse de température de l'ensemble de l'ampoule, y compris donc la zone « froide » 2 de condensation du cadmium.

Avantageusement, mais sans que cela revête un quelconque caractère obligatoire, on peut pratiquer, immédiatement après le passage en vapeur saturante à 0,2 bar, une pause en température de quelques heures, avant d'entreprendre la décroissance de ladite température.

Si en revanche, selon une seconde approche du procédé de l'invention, on attend la décroissance de la température pour atteindre environ 810 °C avant d'opérer le refroidissement de la zone **2** de l'ampoule, alors la pression de vapeur sèche du cadmium s'établit à environ 1 bar. Par abaissement de la température à environ 740 °C dans la zone **2** de l'ampoule, cette pression s'abaisse à 0,7 bar et devient saturante. Ensuite, la pression de cadmium, alors saturante, décroit au fur et à mesure de l'abaissement de température de l'ensemble de l'ampoule jusqu'à l'ambiante.

Ce sont les deux cheminements, respectivement C et D de la figure 5.

On conçoit aisément que l'abaissement de la pression de la vapeur de cadmium au sein de l'ampoule est réglé par le choix de l'abaissement en température.

On poursuit alors le refroidissement jusqu'à atteindre la température ambiante sous pression de vapeur saturante choisie du cadmium et enfin, on brise l'ampoule pour récupérer le mono cristal recherché.

EXEMPLE NUMERIQUE

L'ampoule **1** est typiquement réalisée en silice d'un diamètre intérieur de 90 mn fermé par un bouchon de silice prolongé d'un tube **2** de diamètre intérieur de 24 mn.

L'ampoule contient une charge composée de 1461,343 grammes de cadmium et de 1.658, 800 grammes de tellure, c'est-à-dire une charge strictement stoechiométrique 50% atomique cadmium / 50 %/ atomique tellure.

L'ensemble est destiné à être soumis à un profil de température sensiblement uniforme jusqu'à atteindre 1.100°C. Cette opération constitue la phase de synthèse.

Considérant une densité du liquide approximativement voisine de 5,75 g/cm$^3$, le volume de la charge est déterminé à 542,63 cm$^3$, permettant ainsi d'évaluer en relation avec les dimensions de l'ampoule un volume libre égal à 1.138 cm$^3$.

L'expérience démontre qu'avec l'ampoule du type décrit, le risque d'éclatement ou de brisure interviendrait à une pression voisine de 4 bars.

Souhaitant disposer pour des raisons de sécurité d'une pression maximum de cadmium sous forme de vapeur sèche à l'intérieur de l'ampoule égale à 1,5 bar, l'expression (1) permet alors de déterminer la quantité en excès de cadmium nécessaire à la valeur de 1,699 grammes (environ 1,7 g), qui est ajouté à la charge strictement stoechiométrique mentionnée précédemment.

Après adjonction de cette quantité en excès, et après la phase de synthèse, on soumet alors l'ampoule à un profil de température selon un léger gradient de 1°C par cm, plus chaud en partie basse **3** et moins chaud en partie haute **2**, tel que cela apparaît par ailleurs sur la figure 2. Ce faible gradient est assimilé à une configuration isotherme, notamment au regard des conditions subséquentes de température.

Selon ces conditions, l'ensemble de l'ampoule, que ce soit en partie haute **2** qu'a fortiori en partie basse **3**, légèrement plus chaude, n'est occupée que par une vapeur sèche de cadmium, à l'exception toutefois du composé CdTe alors liquide.

L'abaissement lent en température de l'ensemble aboutit, comme déjà dit, à la cristallisation dudit composé CdTe à partir de la surface du bain liquide dans le cadre de l'exemple décrit, cette cristallisation étant totale quand le fond de l'ampoule passe en dessous de 1.092 °C, c'est-à-dire la température de fusion/solidification du composé CdTe.

Cette descente en température est poursuivie jusqu'à environ 950 °C dans le cas présent, température à laquelle on applique alors un refroidissement très significatif de la partie haute **2** de faible diamètre de l'ampoule.

Ceci provoque la condensation **6** du cadmium en excès et établit une tension de vapeur saturante et choisie dudit cadmium, qui permet de poursuivre la maîtrise de la stoechiométrie souhaitée, et évite en outre, dans le cas présent, la formation de précipités de cadmium dans le solide cristallisé.

Souhaitant par exemple disposer d'une pression de vapeur saturante de 0,2 bar, on doit maintenir la zone **2** de l'ampoule à environ 650° C selon la littérature précédemment mentionnée (A.N. NESMEYANOV).

La formule (2) a permis alors, de manière connue, de calculer la quantité minimale de cadmium en excès conduisant à cette pression en vapeur saturante, en l'espèce 0,33 gramme.

On observe donc que la quantité de cadmium en excès additionnée à la charge, 1,699 grammes (ou environ 1,7 g) est largement suffisante pour permettre la condensation de cet élément à 0,2 bar.

L'ampoule et sa charge sont alors refroidies à la température ambiante, soit en maintenant l'écart de température de 300° C entre la charge cristallisée et le point froid **2** de l'ampoule, soit en appliquant une procédure différente faisant évoluer cet écart.

Ainsi que l'on peut l'observer sur la figure 4, l'extrémité dite froide de l'ampoule est, pour le présent exemple, avantageusement aménagée de manière à éviter le ruissellement du cadmium se condensant en direction de la partie inférieure chaude **3** de l'ampoule. La configuration représentée sur la figure 4 est réalisée de manière classique par les techniciens verriers.

On conçoit aisément à la lecture de la description qui précède l'avantage significatif procuré par l'invention. Celle-ci permet ainsi de synthétiser et cristalliser sous pression de vapeur contrôlée, d'abord sèche puis saturante, un composé semi-conducteur dans une seule ampoule et en une seule opération, en enchaînant sans refroidissement et dans le même équipement les étapes de synthèse puis de cristallisation, et enfin de refroidissement sous vapeur maitrisée de cadmium, et de manière générale, de l'un des constituants du matériau semi-conducteur composite souhaité.

L'avantage sur le plan industriel et économique est donc apparent.

En outre, l'invention peut être mise en oeuvre quelle que soit la zone de positionnement respectif du matériau cristallisé ou en cours de cristallisation et de la zone de gestion de la pression du constituant en excès, dans la mesure où lorsque la charge est à l'état liquide, l'excès dudit constituant en excès se retrouve à l'état de vapeur sèche. Ainsi, la zone de gestion de la pression du constituant en excès peut être localisée au dessus ou en dessous de la charge, quel que soit le mode de croissance mis en oeuvre, c'est-à-dire par le fond ou par la surface.

**Revendications**

1. Procédé pour la réalisation d'un matériau semi-conducteur composé cristallisé, notamment de type II-VI, consistant à synthétiser ledit matériau par fusion et réaction entre eux de ses constituants, lesdits constituants étant placés sous forme élémentaire constituant une charge dans une ampoule scellée (1), puis à cristalliser le matériau semi-conducteur résultant de cette opération alors sous forme liquide par refroidissement de l'ampoule selon un gradient thermique déterminé, *caractérisé* **en ce qu'**il consiste en outre :

   - à augmenter au sein de la charge la proportion de l'un des constituants dudit matériau au delà des proportions stoechiométriques du matériau semi-conducteur à synthétiser, définissant ainsi un excès de l'un desdits constituants ;
   - à soumettre l'intégralité de l'ampoule scellée ainsi munie de la charge à une température supérieure ou égale à la température de fusion du matériau semi-conducteur composé à synthétiser, induisant d'une part, la fusion effective de la charge et la réaction de ses constituants alors sous forme liquide entre eux, et d'autre part, la transformation en vapeur sèche de l'excès du constituant en excès ;
   - à soumettre alors l'ampoule à un gradient faible de température et à un abaissement progressif de la température, propres à induire la cristallisation du matériau semi-conducteur composé en résultant, alors sous forme liquide, en proportion stoechiométrique, l'excès de constituant en excès demeurant sous forme de vapeur sèche ;
   - puis, après cristallisation et avoir entrepris le refroidissement du matériau semi-conducteur, à soumettre la partie (2) de l'ampoule hors le lieu de présence du matériau semi-conducteur cristallisé, à un abaissement de température apte à modifier le régime de pression de vapeur de l'excès du constituant en excès, afin de l'amener à un régime de vapeur saturante ;
   - et enfin, à refroidir l'ensemble jusqu'à température ambiante.

2. Procédé pour la réalisation d'un matériau semi-conducteur composé cristallisé selon la revendication 1, *caractérisé* **en ce que** la quantité de l'excès du constituant en excès est comprise entre deux valeurs :

   - une valeur supérieure, pour laquelle cette quantité est au plus égale à la quantité dudit constituant correspondant à l'établissement, pour une température légèrement supérieure ou égale à la température de fusion du matériau semi-conducteur composé à réaliser, d'une pression haute dudit constituant, alors sous forme de vapeur sèche, inférieure à la pression de l'éclatement de l'ampoule,
   - et une valeur inférieure, pour laquelle cette quantité est au moins égale à la quantité dudit constituant correspondant à l'établissement, pour une température comprise entre 400 et 800 °C d'une pression de vapeur saturante au niveau de la partie (2) de l'ampoule hors le lieu de présence du matériau semi-conducteur cristallisé ; ces deux valeurs étant déterminées par application de la loi de MARIOTTE.

3. Procédé pour la réalisation d'un matériau semi-conducteur composé cristallisé selon l'une des revendications 1 et 2, *caractérisé* **en ce que** l'ampoule scellée comporte deux zones, présentant deux diamètres différents :

   - une zone de plus grand diamètre (3), destinée à servir de lieu de réception de la charge à cristalliser ;
   - une zone de plus petit diamètre (2), en continuité avec la zone de plus grand diamètre, destinée à être soumise à la gestion localisée de température et corollairement au changement de nature, de vapeur sèche à vapeur saturante, de la vapeur du constituant en excès.

4. Procédé pour la réalisation d'un matériau semi-conducteur composé cristallisé selon l'une des revendications 1 à 3, *caractérisé* **en ce que** les matériaux synthétisés sont les matériaux binaires de type CdTe ou ZnTe, les matériaux ternaires de formule générique CdZnTe, CdTeSe et les matériaux quaternaires de type CdZnTeSe.

Four
Basse Θ°

Cd ou Te

Température du four

Distance

Température
du réservoir

Four
HauteΘ°

CdTe

Température
de solidification

## Fig. 1

ART ANTERIEUR

Position le long de l'ampoule

2

1

3

5

4

600° C   700° C   800° C   0900° C   1000° C   1100° C

T°C

## Fig. 2

**Fig. 3**

**Fig. 4**

**Fig. 5**

**EP 2 363 515 A1**

Europäisches Patentamt
European Patent Office
Office européen des brevets

**RAPPORT DE RECHERCHE EUROPEENNE**

Numéro de la demande

EP 11 30 5144

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A,D | US 4 190 486 A (KYLE NANSE R [US]) 26 février 1980 (1980-02-26) * colonne 4, ligne 48 - colonne 5, ligne 39 * ----- | 1-4 | INV. C30B11/00 C30B29/48 |
| A | US 3 933 435 A (MENASHI WILSON P ET AL) 20 janvier 1976 (1976-01-20) * colonne 1, ligne 43-60 * ----- | 1-4 | |

DOMAINES TECHNIQUES RECHERCHES (IPC)

C30B

Le présent rapport a été établi pour toutes les revendications

| Lieu de la recherche | Date d'achèvement de la recherche | Examinateur |
|---|---|---|
| Munich | 12 mai 2011 | Brisson, Olivier |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 11 30 5144

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

12-05-2011

| Document brevet cité au rapport de recherche | | Date de publication | Membre(s) de la famille de brevet(s) | Date de publication |
|---|---|---|---|---|
| US 4190486 | A | 26-02-1980 | AUCUN | |
| US 3933435 | A | 20-01-1976 | AUCUN | |

EPO FORM P0460

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4190486 A
- US 5603763 A

**Littérature non-brevet citée dans la description**

- **LI WANWAN et al.** Study on the effect of Cd diffusion annealing on the electrical properties of CdZnTe. *Journal of Crystal Growth,* 2006, vol. 292
- **H.R. VYDYANATH et al.** Recipe to minimize Te precipitation in CdTe and (Cd,Zn)Te crystals. *J ; Vac. Sci. Technol. B,* Juillet 1992, vol. 10 (4
- **A.N. NESMEYANOV.** VAPOR PRESSURE OF THE CHEMICAL ELEMENTS. Elsevier Publishing Company